# EUROPEAN PATENT APPLICATION

(11) **EP 4 598 300 A1**
(43) Date of publication of application: **06.08.2025**
(21) Application number: 25154381.5
(22) Date of filing: 28.01.2025
(51) Int. Cl.: H10D 30/67

(54) **TRANSISTOR AND DISPLAY DEVICE INCLUDING THE SAME**

(30) Priority: 02.02.2024 KR 20240016643
(71) Applicant: LG Display Co., Ltd., Seoul 150-721 (KR)
(72) Inventor: MOON, Sung Ho, Paju-si, Gyeonggi-do (KR)
(74) Representative: Viering, Jentschura & Partner mbB Patent- und Rechtsanwälte

(57) **Abstract**

Disclosed are a transistor including an active layer (ACT), a gate electrode (G) having an overlap area of a first length (L) and a first width (W) overlapped with the active layer (ACT), and a gate insulating film (125) provided between the active layer (ACT) and the gate electrode (G). The active layer (ACT) may have an intrinsic area (UDP2, UDP3) protruding from the center of the first width (W) to a non-overlap area not overlapped with the gate electrode (G) more than the edge (E) of the first width (W), and a display device (1000) including the same.

## Description

This application claims the benefit of Korean Patent Application No. 10-2024-0016643, filed on February 2, 2024.

### BACKGROUND OF THE INVENTION

### Field of the Invention

The present disclosure relates to a transistor, and more particularly to a transistor with improved reliability and a display device including the same.

### Discussion of the Related Art

Display devices for displaying images on TVs, monitors, smartphones, tablet computers, and laptop computers, etc. are used in various ways and forms.

A display device includes a plurality of pixels configured to display an image and a transistor configured to control the operation of each pixel.

The display device includes a plurality of pixels and a plurality of driving and switching elements to drive and control the pixels. The driving and switching elements may be constituted by transistors, which are widely used in integrated circuits as well as in pixels.

In recent years, various research and development has been conducted to improve the performance and reliability of transistors.

### SUMMARY OF THE INVENTION

Embodiments of the present disclosure provide a transistor configured such that an offset area is provided in a channel width direction of an active layer, whereby it is possible to prevent the effective channel length formed upon ion doping using a gate electrode from varying in the width direction.

Embodiments of the present disclosure provide a transistor configured such that a change in the effective channel length of a transistor including an oxide semiconductor is controlled, thereby improving reliability of the transistor.

Embodiments of the present disclosure provide a transistor configured such that a change in the effective channel length is prevented or reduced even if the transistor has a large channel width, thereby preventing threshold voltage variation.

Embodiments of the present disclosure provide a display device including a large-width transistor with element stability in a display area or a non-display area.

Embodiments of the present disclosure provide a display device configured such that threshold voltage sensitivity due to channel width variation is reduced, thereby providing high design freedom and realizing a narrow bezel by disposing a high power transistor in a non-display area at a small size.

Embodiments of the present disclosure provide a display device capable of reducing the defect rate of the display device, thereby reducing the quantity of materials used in the overall manufacturing process, such as gas and etching liquid for manufacturing the display device, and thus reducing greenhouse gas generation due to the manufacturing process. Embodiments of the present disclosure provide a transistor according to claim 1. Further embodiments are described in the dependent claims.

A transistor according to an embodiment of the present disclosure includes an active layer, a gate electrode having an overlap area of a first length and a first width overlapped with the active layer, and a gate insulating film provided between the active layer and the gate electrode, wherein the active layer has an intrinsic area protruding from a center of the first width to a non-overlap area not overlapped with the gate electrode more than an edge of the first width.

A display device according to an embodiment of the present disclosure includes a substrate having a display area and a non-display area, a plurality of gate lines and a plurality of data lines intersecting each other in the display area, the plurality of gate lines and the plurality of data lines being configured to define a plurality of subpixels, a first transistor and a second transistor provided in at least one of the plurality of subpixels, a light emitting element connected to the second transistor, and a third transistor provided in the non-display area, wherein at least one of the first transistor, the second transistor, and the third transistor includes an active layer, a gate electrode having an overlap area overlapped with the active layer, and a gate insulating film provided between the active layer and the gate electrode. The active layer may have an intrinsic area protruding from a center of a width of the overlap area to a non-overlap area not overlapped with the gate electrode more than an edge of the width of the overlap area.

### BRIEF DESCRIPTION OF THE DRAWINGS

The accompanying drawings, which are included to provide a further understanding of the present disclosure and are incorporated in and constitute a part of this application, illustrate embodiment(s) of the present disclosure and together with the description serve to explain the principle of the present disclosure. In the drawings:
FIG. 1 is a schematic plan view showing a display device according to an embodiment of the present disclosure;
FIG. 2 is a circuit diagram showing a subpixel according to an embodiment of the present disclosure;
FIG. 3 is a plan view showing a transistor according to an embodiment of the present disclosure;
FIG. 4 is a plan view showing an active layer;
FIG. 5 is a sectional view taken along line I-I' of FIG. 3;
FIG. 6 is a sectional view taken along line II-II' of FIG. 3;
FIG. 7 is a sectional view taken along line III-III' of FIG. 3;
FIGs. 8A and 8B are a plan view and a sectional view of a transistor in which a doped area formed using a gate electrode as a mask is diffused;
FIGs. 9A and 9B are a plan view and a sectional view showing formation of a doped area of a transistor according to an embodiment of the present disclosure;
FIG. 10 is a sectional view showing first and second transistors according to an embodiment of the present disclosure;
FIG. 11 is a plan view showing a third transistor according to an embodiment of the present disclosure; and
FIG. 12 is a sectional view showing a display device according to an embodiment of the present disclosure.

### DETAILED DESCRIPTION OF THE INVENTION

Hereinafter, preferred embodiments of the present disclosure will be described with reference to the accompanying drawings. Wherever possible, the same reference numbers will be used throughout the drawings to refer to the same or like parts, unless otherwise specified. In the following description of the present disclosure, where the detailed description of the relevant known steps, elements, functions, technologies, and configurations can unnecessarily obscure an important point of the present disclosure, a detailed description of such steps, elements, functions, technologies, and configurations may be omitted. In addition, the names of elements used in the following description are selected in consideration of clarity of description of the specification, and can differ from the names of elements of actual products.

The shapes, sizes, ratios, angles, numbers, and the like, which are illustrated in the drawings to describe various example embodiments of the present disclosure are merely given by way of example. The disclosure is not limited to the illustrations in the drawings. In the present disclosure, where terms such as "including," "having," "comprising," and the like are used, one or more components can be added, unless the term, such as "only," is used. The terminology used herein is to describe particular aspects and is not intended to limit the present disclosure. As used herein, the terms "a" and "an" used to describe an element in the singular form is intended to include a plurality of elements. An element described in the singular form is intended to include a plurality of elements, and vice versa, unless the context clearly indicates otherwise.

In construing a component or numerical value, the component or the numerical value is to be construed as including an error or tolerance range even where no explicit description of such an error or tolerance range is provided.

In describing the various example embodiments of the present disclosure, where the positional relationship between two elements is described using terms, such as "on", "above", "under" and "next to", at least one intervening element can be present between the two elements, unless "immediate(ly)" or "direct(ly)" or "close(ly) is used. It will be understood that when an element or layer is referred to as being "connected to", or "coupled to" another element or layer, it can be directly connected to or coupled to the other element or layer, or one or more intervening elements or layers can be present.

In describing the various example embodiments of the present disclosure, when terms such as "after," "subsequently," "next," and "before," are used to describe the temporal relationship between two events, another event can occur therebetween, unless a more limiting term, such as "just," "immediate(ly)," or "directly" is used.

In describing the various example embodiments of the present disclosure, terms such as "first" and "second" can be used to describe a variety of components. These terms aim to distinguish the same or similar components from one another and do not limit the components. Accordingly, throughout the specification, a "first" component can be the same as a "second" component within the technical concept of the present disclosure, unless specifically mentioned otherwise.

Features of various embodiments of the present disclosure can be partially or overall coupled to or combined with each other, and can be variously inter-operated with each other and driven technically as those skilled in the art can sufficiently understand. The embodiments of the present disclosure can be carried out independently from each other, or can be carried out together in a co-dependent relationship.

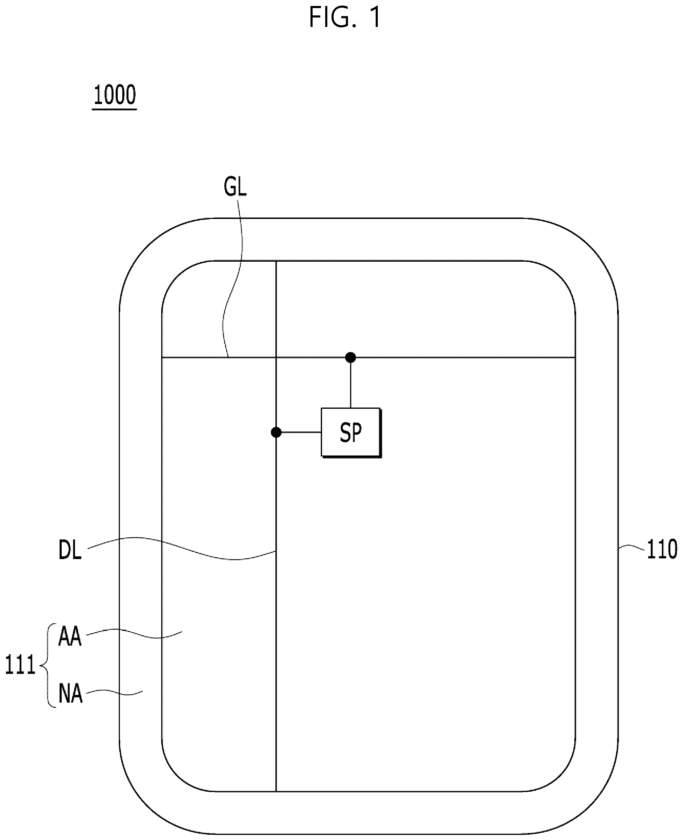

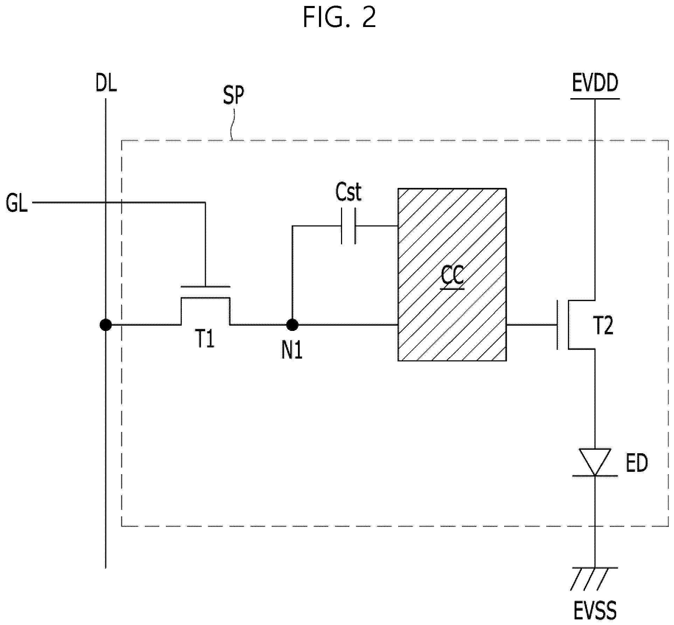

FIG. 1 is a schematic plan view showing a display device according to an embodiment of the present disclosure, and FIG. 2 is a circuit diagram showing a subpixel according to an embodiment of the present disclosure.

Referring to FIGs. 1 and 2, the display device 1000 according to the embodiment of the present disclosure may include a display panel 110, wherein the display panel 110 may include a substrate 111 including a display area AA and a non-display area NA surrounding the display area AA and a driving unit connected to the substrate 111. The driving unit may be integrated into the substrate 111 and formed together with an array provided in the display area AA, may be chip-on-glass (COG) connected to the substrate 111, may be chip-on-film (COF) connected to the substrate 111, or may be connected to a printed circuit board via a connector.

The display area AA is an area configured to display an image. A plurality of subpixels SP may be disposed in the display area AA of the display panel 110, and an image may be displayed using the plurality of subpixels SP.

The display device 1000 may include a display panel 110 and a case (not shown) configured to receive the side of the display panel 110 and the bottom of the display panel 110. The non-display area NA of the display panel 110 may be hidden by the case or covered by a separate printed film. A printed circuit film and/or a battery may be provided between the bottom of the display panel 110 and the case.

The area where the plurality of subpixels SP is disposed may be the display area AA, and the area other than the display area AA may be the non-display area NA.

The non-display area NA may an edge area surrounding the display area AA that displays the image. At least one driving unit configured to drive the plurality of subpixels SP may be disposed in the non-display area NA. The driving unit may include a gate-in-panel GIP. The gate-in-panel GIP may be connected to a plurality of gate lines GL in the display area AA, and may sequentially supply a gate voltage signal to the plurality of gate lines GL.

Various additional elements configured to drive the subpixels SP in the display area AA may be further disposed in the non-display area NA.

At least one of the plurality of subpixels SP may include a first transistor T1, a second transistor T2, a storage capacitor Cst, a compensation circuit CC, and a light emitting element ED, as shown in FIG. 2.

In one example, the first transistor T1 may be a switching transistor and the second transistor T2 may be a driving transistor.

A first electrode (e.g., a drain electrode) of the first transistor T1 is electrically connected to a data line DL, and a second electrode (e.g., a source electrode) of the first transistor T1 is electrically connected to a first node N1. A gate electrode of the first transistor T1 is electrically connected to a gate line GL. The first transistor T1 transmits a data signal supplied via the data line DL to the first node N1 in response to a scan signal supplied via the gate line GL.

The storage capacitor Cst is electrically connected to the first node N1 to charge voltage applied to the first node N1.

A first electrode (e.g., a drain electrode) of the second transistor T2 receives a high potential drive voltage (EVDD), and a second electrode (e.g., a source electrode) of the second transistor T2 is electrically connected to a first electrode (e.g., an anode) of the light emitting element ED. The second transistor T2 may control the amount of driving current flowing to the light emitting element ED in response to voltage applied to the gate electrode.

A semiconductor layer of the first transistor T1 and/or the second transistor T2 may include, without being limited to, silicon such as amorphous silicon (a-Si), polycrystalline silicon (poly-Si), or low-temperature polycrystalline silicon (poly-Si), or an oxide, such as indium-gallium-zinc-oxide (IGZO). At least one of the first and second transistors T1 and T2 may include an oxide semiconductor layer, which may be formed at a lower temperature than other materials, may maintain amorphous properties, and may have high mobility.

The light emitting element ED outputs light corresponding to the driving current. The light emitting element ED may output light corresponding to any one of red, green, blue, and white.

The light emitting element ED may include an anode, an intermediate layer disposed on the anode, and a cathode to which a common voltage EVSS is supplied. The intermediate layer may include at least one light emitting layer, which may be configured to emit the same color of light on a pixel-by-pixel basis, such as white light or may be configured to emit different colors on a subpixel-by-subpixel basis, such as red, green, or blue light. The intermediate layer may include various common and functional layers configured to efficiently supply holes and electrons to the light emitting layer.

The light emitting element ED may be a front-emitting diode or a back-emitting diode.

The compensation circuit CC may be further provided in the subpixel SP to compensate for a threshold voltage of the second transistor T2. The compensation circuit CC may include one or more transistors. The compensation circuit CC may include one or more transistors and capacitors, and may be variously configured depending on a compensation method. The subpixel including the compensation circuit CC may include various circuits with different numbers of transistors and/or capacitors, such as 3T1C, 4T2C, 5T2C, 6T1C, 6T2C, 7T1C, and 7T2C.

Hereinafter, a transistor according to an embodiment of the present disclosure will be described. The transistor may be applied to a subpixel including a compensation circuit CC or to a driving unit of a non-display area, such as transistors included in a gate-in-panel (GIP).

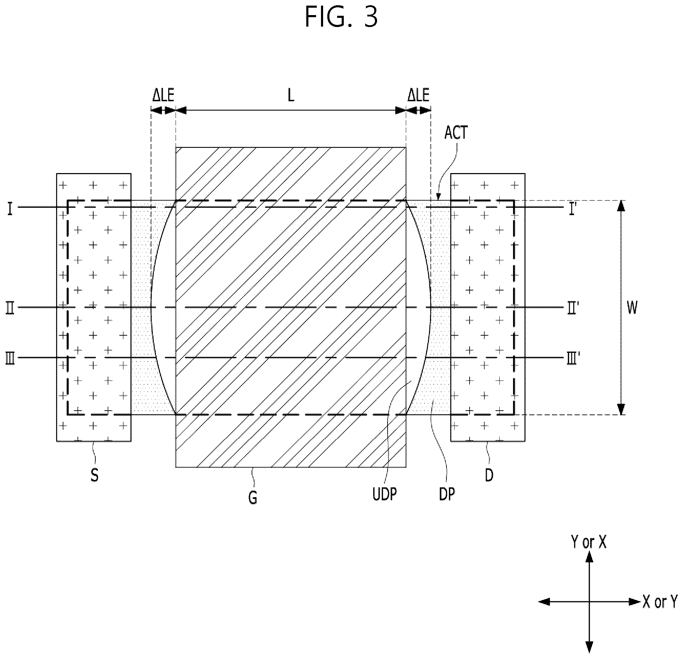

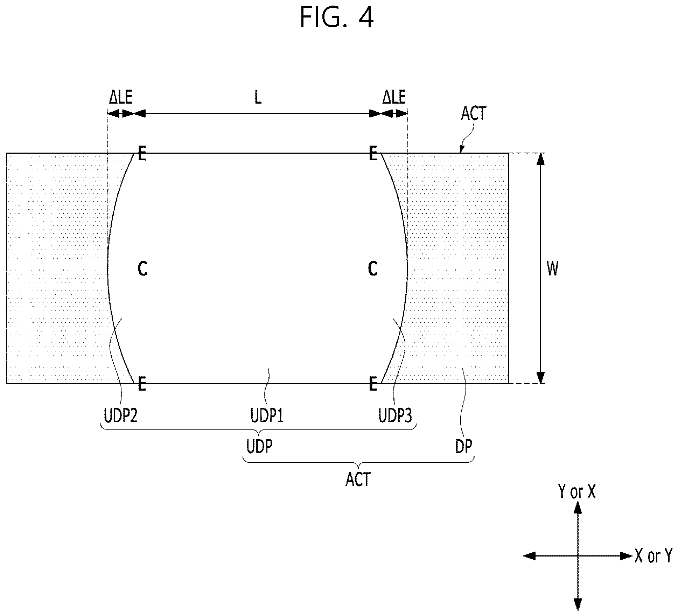

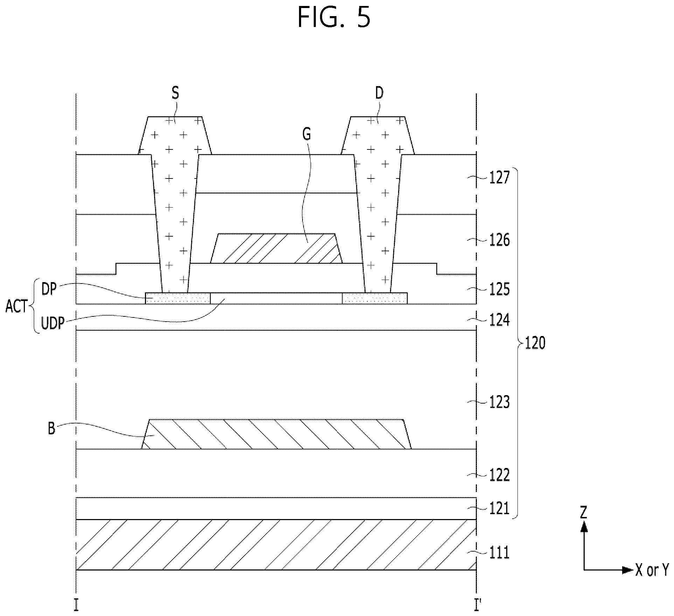

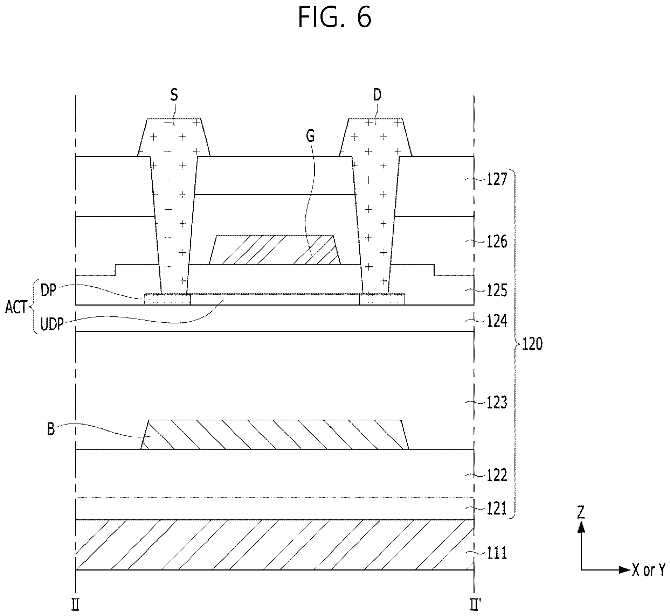

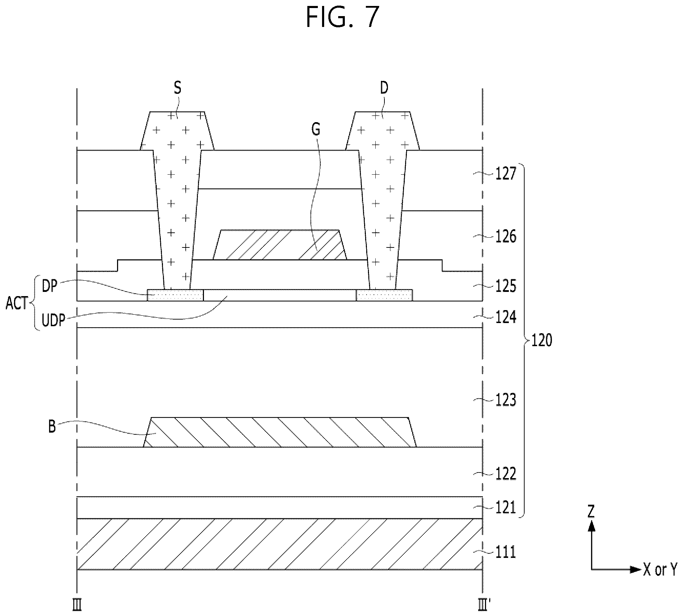

FIG. 3 is a plan view showing a transistor according to an embodiment of the present disclosure. FIG. 4 is a plan view showing an active layer. FIG. 5 is a sectional view taken along line I-I' of FIG. 3, FIG. 6 is a sectional view taken along line II-II' of FIG. 3, and FIG. 7 is a sectional view taken along line III-III' of FIG. 3.

As shown in FIGs. 3 to 7, the transistor according to the embodiment of the present disclosure includes an active layer ACT and a gate electrode G having an overlap area (also referred to as the first intrinsic area UDP1) which has a length L in a first direction (X-axis or Y-axis) and a width W in a second direction (Y-axis or X-axis) intersecting the first direction overlapped with the active layer ACT. In an embodiment as shown in Fig. 3, the first direction may be the length direction of the first intrinsic area UDP1, and the second direction may be the width direction of the first intrinsic area UDP1.

A gate insulating film 125 is provided between the active layer ACT and the gate electrode G.

The active layer ACT may have intrinsic areas UDP2 and UDP3 (i.e., the second intrinsic area UDP2 and the third intrinsic area UDP3) that protrude from the center of the width W of the overlap area with the gate electrode G to a non-overlap area not overlapped with the gate electrode G more than the edge of the width.

Intrinsic areas UDP1, UDP2, and UDP3 described herein are undoped areas, which are areas covered by a mask or the gate electrode G in a doping process and are thus undoped. In the embodiment of the present disclosure, the active layer ACT has an intrinsic area outside the gate electrode G, and therefore a separate mask may be used in addition to the gate electrode G in the doping process.

The intrinsic areas UDP2 and UDP3 may be gradually reduced from the center (C) of the width W of the overlap area between the active layer ACT and the gate electrode G to the edge E of the width W. The active layer ACT further has intrinsic areas UDP2 and UDP3 provided in the area deviating from the gate electrode G so as to protrude toward the edge of the active layer ACT, in addition to the intrinsic area UDP1 overlapping the gate electrode G, and each of the intrinsic areas UDP2 and UDP3 has a "circular arc" shape at the edge of the gate electrode G in the plan view of FIG. 1.

As shown in FIG. 4, in the active layer ACT, the intrinsic areas UDP2 and UDP3 in the non-overlap area not overlapped with the gate electrode G are connected to the intrinsic area UDP1 in the overlap area with the gate electrode G, and the active layer ACT may have a doped area DP in the non-overlap area not overlapped with the gate electrode G excluding the intrinsic areas UDP2 and UDP3.

The active layer ACT of the transistor according to the embodiment of the present disclosure has intrinsic areas UDP1, UDP2, and UDP3 larger than the area overlapping the gate electrode G.

The intrinsic areas UDP2 and UDP3 in the active layer ACT deviating from the gate electrode G function as offset areas. The reason that the center C of the width W of the active layer ACT has the intrinsic areas UDP2 and UDP3 with larger areas toward the center C of the active layer ACT than the edge E of the width W is to prepare for changes due to the difference in heat generation, since more heat is generated at the center C than at the edge E in the width direction during heat treatment or driving of the transistor after the doping process.

Specifically, heat is generated in the active layer ACT, and a dopant contained in the doped area DP is diffused toward the intrinsic area adjacent thereto, wherein diffusion is stronger at the center C than at the edge E in the width W of the active layer ACT where a relatively large amount of Joule heat is generated, and the channel length reduction ΔL may be increased in the width W direction. The active layer ACT according to the embodiment of the present disclosure may have intrinsic areas UDP2 and UDP3 having larger areas at the center C of the width W of the active layer ACT, whereby, even if the dopant is diffused, the diffused dopant does not overlap the gate electrode G, and therefore it is possible to maintain the substantially effective channel length Leff at the level of the length L of the gate electrode G overlapping the active layer ACT. Referring to FIGs. 3 and 4, the length of the channel of the active layer ACT may include the length L of the area overlapping the gate electrode G, and the extension length ΔLE of the intrinsic areas UDP2 and UDP3 provided in the active layer ACT deviating from the gate electrode G. The extension length ΔLE of the active layer ACT deviating from the gate electrode G is changed in the width direction considering the amount of diffusion of the dopant. In this case, the maximum extension length of the intrinsic areas UDP2 and UDP3 provided in the active layer ACT deviating from the gate electrode G may be at the center C of the width W of the active layer ACT. Accordingly, the length of the initial channel after transistor formation may be greatest at the center C of the width W of the overlap area between the active layer ACT and the gate electrode G. If the diffusion of the dopant is increased by joule heat generation during heat treatment or driving of the transistor, the intrinsic areas may be reduced and the extension length ΔLE may approach a value of almost zero. Even in this case, the amount of diffusion of the dopant is changed in the width direction, and since the intrinsic areas UDP2 and UDP3 are preset in the active layer ACT due to a change in diffusion amount, the boundary between the final intrinsic area and the doped area after diffusion may be similar to the edge of the gate electrode G.

In the transistor according to the embodiment of the present disclosure, the intrinsic areas UDP2 and UDP3 are provided outside the gate electrode G, wherein the distances of the intrinsic areas UDP2 and UDP3 are set differently in the width direction due to the different amounts of generation of joule heat in the respective areas when the diffusion distance of the dopant is calculated after doping.

Here, the dopant included in the doped area DP may be, for example, boron, phosphorus, or fluorine. However, examples of the dopant are not limited thereto, and an element having a different molecular weight may be used as long as the element can exhibit conductorization characteristics upon doping, taking into account the crystalline or amorphous nature of the active layer ACT.

The X direction in FIGs. 3 and 4 may be a direction parallel to the gate line GL in FIG. 1, and the Y direction may be a direction parallel to the data line DL in FIG. 1. In the transistor according to the embodiment of the present disclosure, the width W of the active layer ACT may be a width in the X-axis or the Y-axis direction, and the length L may be a length in a direction intersecting the width W. That is, if the width W of the active layer ACT is a width in the X-axis direction, the length L of the active layer ACT may be a length in the Y-axis direction. Alternatively, if the width W of the active layer ACT is a width in the Y-axis direction, the length L of the active layer ACT may be a length in the X-axis direction.

In the transistor according to the embodiment of the present disclosure, the intrinsic areas UDP2 and UDP3 are further provided outside the gate electrode G to prevent permeation of the dopant into the gate electrode G while thermally being diffused. If doping is performed by using only the gate electrode as a mask, joule heat is increased at the center of the channel width during subsequent heat treatment or driving of the transistor and the effective length Leff of the channel at the center of the channel width may be extremely decreased; however, the transistor according to the embodiment of the present disclosure is capable of preventing these problems.

As shown in FIGs. 3 to 7, the transistor according to the embodiment of the present disclosure may further include a source electrode S and a drain electrode D connected respectively to the doped areas DP of the active layer ACT located at both sides of the gate electrode G. The doped area DP is a conductorized area in the active layer ACT and is in direct contact with a metal. The doped area DP functions as a source-drain area in the active layer ACT. In the active layer ACT, the initially doped area DP may be spaced from the edge of the gate electrode G by the disposition length of the intrinsic areas UDP2 and UDP3.

The active layer ACT may include an oxide semiconductor. For example, the active layer ACT may be made of an oxide including at least one, preferably two or more, of indium, gallium, zinc, tin, and iron. However, the active layer ACT according to the embodiment of the present disclosure is not limited to the oxide semiconductor. As another example, the active layer ACT may include silicon, such as amorphous silicon (a-Si), polycrystalline silicon (poly-Si), or low-temperature polycrystalline silicon (poly-Si).

When the active layer ACT is made of an oxide semiconductor, it is possible to omit the crystallization process, which requires high temperatures, while retaining amorphous nature and having high mobility.

In the structure where doping is performed using the gate electrode as a mask, the channel length reduction ΔL may be increased in proportion to the channel width. Channel length reduction means that the conductorized area of the active layer increases, which reduces the area of the entire effective channel of the active layer and reduces the threshold voltage of the active layer required for switching, and the threshold voltage tends to be shifted to a negative value in proportion to the channel length reduction ΔL.

Meanwhile, in recent years, there have been attempts to gradually increase the size of the active layer to form transistors with high power output, and to realize channel size, especially large width, accordingly. However, as described above, as the width of the channel increases, the effect of the channel length reduction ΔL due to the difference in Joule heat generation is intensified in the width direction, and since the doped areas are disposed on both sides of the channel in the intrinsic area, a channel length reduction of 2ΔL may occur when the width of the channel increases in the structure where doping is performed by using the gate electrode as a mask. Accordingly, in the structure in which doping is performed using the gate electrode as a mask, when implementing an active layer with a wide channel, the variability of the threshold voltage value due to the channel length reduction increases as the width increases, which means that the threshold voltage sensitivity to changes in width increases.

The transistor according to the embodiment of the present disclosure may prevent or minimize channel length variation even when having a wide channel by having the intrinsic area deviating from the gate electrode in the channel width direction so as to be different for respective areas. Therefore, when applied to a switching transistor or a gate-in-panel (GIP) that requires a wide channel for high output, the channel width reduction may be prevented in the wide channel transistor, and threshold voltage fluctuation may be prevented as the width increases.

Furthermore, in the transistor according to the embodiment of the present disclosure, width dependence or width sensitivity of the active layer having a large width may be prevented, enabling a transistor with high power output to be reliably realized with a large width, thereby improving design freedom and achieving a narrow bezel when applied to a driving unit.

The sectional structure of the transistor according to the embodiment of the present disclosure will be described with reference to FIGs. 5 to 7.

A first insulating film 121 and a second insulating film 122 are sequentially disposed on the substrate 111. The first insulating film 121 and the second insulating film 122 are disposed on the substrate 111 to prevent impurities, such as moisture or charged particles, permeating through the substrate 111 from permeating the structure on the substrate 111, and may function to planarize the surface. The first and second insulating films 121 and 122 may function as buffer layers.

For example, each of the first insulating film 121 and the second insulating film 122 may include at least one of a silicon oxide film (SiOx), a silicon nitride film (SiNx), and a silicon oxynitride film (SiOxNy), or a multilayer film formed by stacking the inorganic films.

A light blocking metal B is disposed on the second insulating film 122. The light blocking metal B is located under the active layer ACT formed thereon, and may prevent external light entering from the substrate 111 side from affecting the active layer ACT.

For example, the light blocking metal B may be made of a conductive metal material, and specifically, the conductive metal material may include at least one of an aluminum-based metal, such as aluminum (Al) or an aluminum alloy, a silver-based metal, such as silver (Ag) or a silver alloy, a copper-based metal, such as copper (Cu) or a copper alloy, a molybdenum-based metal, such as molybdenum (Mo) or a molybdenum alloy, chromium (Cr), tantalum (Ta), neodymium (Nd), and titanium (Ti). In some cases, when the substrate 111 includes two active layers, one of the active layers may be a conductorized layer.

A third insulating film 123 and a fourth insulating film 124 may be disposed on the second insulating film 122 where the light blocking metal B is located.

Each of the third and fourth insulating films 123 and 124 includes an inorganic insulating film.

An active layer ACT is provided on the fourth insulating film 124 while overlapping the light blocking metal B.

A gate insulating film 125 is provided on the active layer ACT.

If the active layer ACT is made of an oxide semiconductor, no hydrogen particles are discharged during heat treatment when each of the fourth insulating film 124 and the gate insulating film 125 is made of a silicon oxide film, thereby preventing reliability of the active layer ACT disposed adjacent to the fourth insulating film 124 and the gate insulating film 125 from being reduced due to hydrogen particles during the process.

A gate electrode G having an overlap area of length L in the first direction (X-axis or Y-axis) and a width W in the second direction (Y-axis or X-axis) intersecting the first direction overlapped with the active layer ACT, as shown in FIG. 3, is provided on the gate insulating film 125.

The length L of the overlap area between the active layer ACT and the gate electrode G is located between the source electrode S and the drain electrode D in a longitudinal direction of the channel.

The gate electrode G is made of, for example, a conductive metal material, and the conductive metal material may include at least one of an aluminum-based metal, such as aluminum (Al) or an aluminum alloy, a silver-based metal, such as silver (Ag) or a silver alloy, a copper-based metal, such as copper (Cu) or a copper alloy, a molybdenum-based metal, such as molybdenum (Mo) or a molybdenum alloy, chromium (Cr), tantalum (Ta), neodymium (Nd), and titanium (Ti).

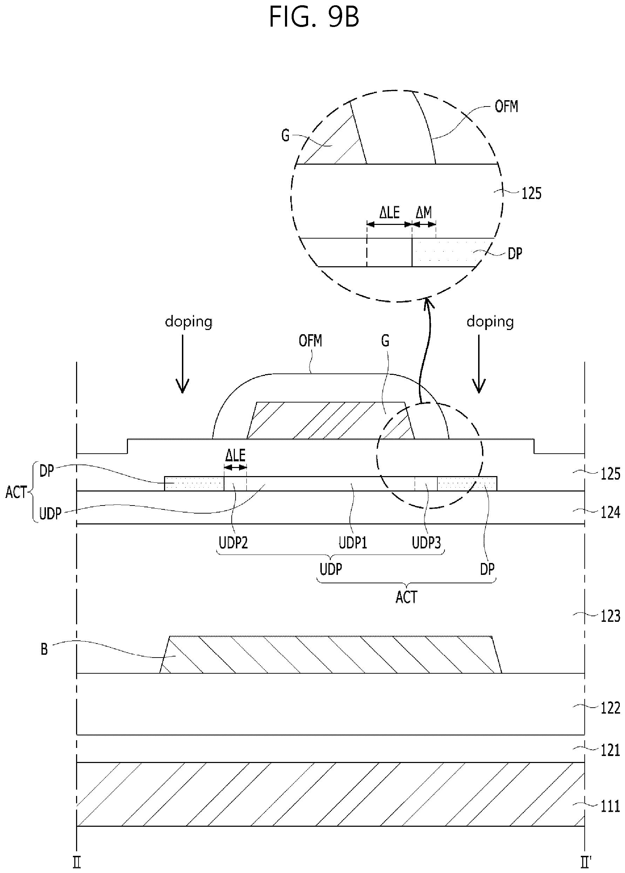

After formation of the gate electrode G, a mask (see an offset mask OFM in FIG. 9B) configured to cover at least considerable portions of undoped areas (the intrinsic areas UDP2 and UDP3) of FIGs. 3 and 4 around the gate electrode G is prepared, and the active layer ACT not covered by the mask and the gate electrode G is doped with dopant ions to form a doped area DP.

As shown in FIG. 5, the section cut in a channel length L direction so as to correspond to the edge E of the width W of the active layer channel shows that the boundary between the doped area DP and the intrinsic area UDP is close to the edge of the gate electrode G.

As shown in FIG. 6, the section cut in the channel length L direction so as to correspond to the center C of the width W of the active layer channel shows that the boundary between the doped area DP and the intrinsic area UDP is spaced apart from the edge of the gate electrode G by a predetermined distance.

As shown in FIG. 7, the section cut in the channel length L direction so as to correspond to the space between the center C and the edge E of the width W of the active layer channel shows that the gate electrode G and the doped area DP are spaced apart from each other by a distance less than the distance between the gate electrode G and the doped area DP shown in FIG. 6.

That is, as shown in FIGs. 3 to 7, the intrinsic areas UDP (UDP1+UDP2+UDP3) have a shape that gradually decreases from the center C of the width W of the area where the active layer ACT overlaps the gate electrode G to the edge E of the width W.

A fifth insulating film 126 and a sixth insulating film 127 are sequentially disposed on the gate insulating film 125 on which the gate electrode G is disposed.

Each of the fifth insulating film 126 and the sixth insulating film 127 may be formed as a single film. Each of the fifth insulating film 126 and the sixth insulating film 127 may be made of an inorganic insulating material.

When the fifth insulating film 126 and the sixth insulating film 127 are sequentially disposed, different inorganic insulating materials may be disposed, or an inorganic film and an organic film may be sequentially disposed. The fifth insulating film 126 may be made of an inorganic insulating material that emits less hydrogen during the heat treatment process than the sixth insulating film 127.

The first to sixth insulating films 121, 122, 123, 124, 126, and 127 and the gate insulating film 125 formed on the substrate 111 may be collectively referred to as an insulating film 120. In the insulating film 120, one of multilayer insulating films between the active layers and the metal layers or between different metal layers may be omitted. In addition, the multilayer insulating films may be formed by sequentially placing different materials or by varying the ratio of the ingredients thereof.

Meanwhile, the light blocking metal B may be connected to the gate electrode G at one side to apply a voltage of the same potential thereto. In this case, the transistor has a dual-gate structure with gate electrodes located above and under the active layer ACT, which enables more precise control of the current flowing through the active layer ACT, and can be realized as an overlapping structure, whereby the area in which the transistor is disposed may be realized without increasing the planar area. In addition, the gate structure may be realized in a small size as a structure in which the light blocking metal B and the gate electrode G overlap each other, compared to a normal gate structure for generating the same current, which is advantageous for forming a high-resolution structure of the display device.

Hereinafter, the structure in which doping is performed using the gate electrode as a mask will be described.

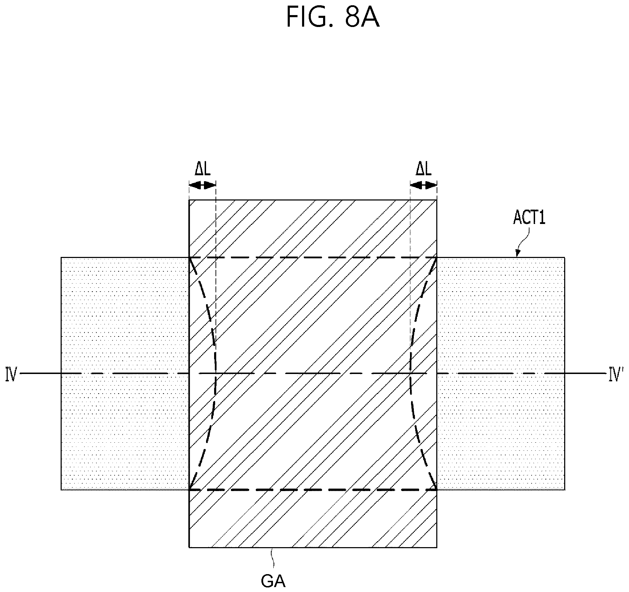

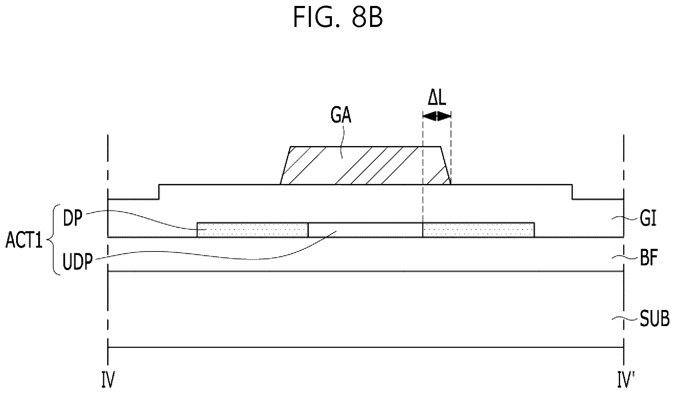

FIGs. 8A and 8B are a plan view and a sectional view of a transistor in which a doped area formed using a gate electrode as a mask is diffused.

As shown in FIG. 8B, a buffer layer BF is formed on a substrate SUB, and then an active layer ACT1 is formed. Subsequently, a gate insulating layer GI is formed so as to cover the active layer ACT1, and a gate electrode GA is formed on the gate insulating layer GI so as to overlap the active layer ACT1. Subsequently, a doping process is performed on the active layer ACT1 on both sides of the gate electrode GA using the gate electrode GA as a mask. After doping, as shown in FIGS. 8A and 8B, the dopant shown does not remain only outside the gate electrode GA, but is diffused into the overlap area with the gate electrode GA, and a channel length reduction ΔL phenomenon may occur in proportion to the diffusion of the dopant.

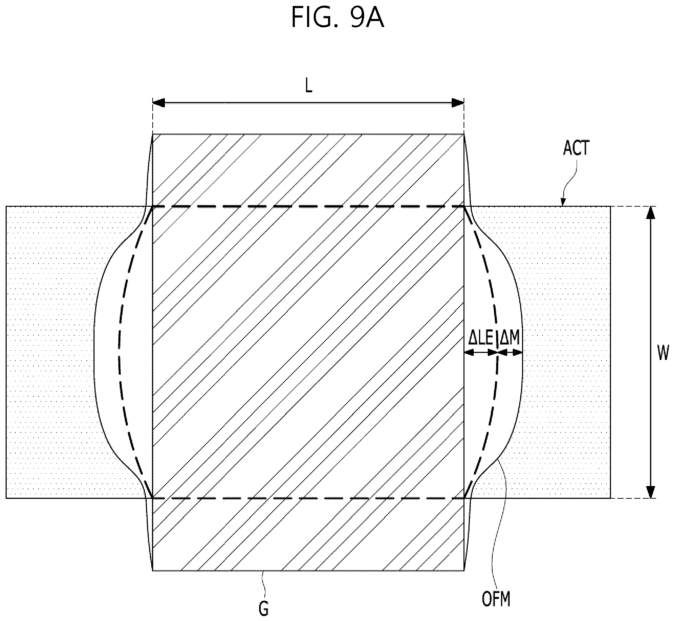

FIGs. 9A and 9B are a plan view and a sectional view showing formation of the doped area of the transistor according to an embodiment of the present disclosure.

As shown in FIG. 9B, in manufacturing the transistor according to the embodiment of the present disclosure, a gate insulating film 125 covering the active layer ACT is formed, and a gate electrode G having an overlap area of length L in the first direction and a width W in the second direction intersecting the first direction is formed with the gate insulating film 125.

Subsequently, as shown in FIGs. 9A and 9B, an offset mask OFM covering the top and the side of the gate electrode G and partially overlapping the active layer ACT on both sides of the gate electrode G is formed. Here, when describing the shape of the offset mask OFM overlapping the active layer ACT with reference to FIG. 9A, the center of the width protrudes more than the edge of the width in the "width W" direction, whereby the offset mask OFM sufficiently covers the intrinsic areas UDP2 and UDP3 described with reference to FIGs. 3 and 4, and a margin area length ΔM is provided in consideration of diffusion in the doping process when the intrinsic areas UDP2 and UDP3 to be formed have an extension distance of the extension length ΔLE. That is, the offset mask OFM has a maximum length of "ΔLE +ΔM" at the center C of the width W of the channel.

Meanwhile, FIG. 9B is a sectional view through the center C of the channel of the active layer ACT of FIG. 9A, taken along line II-II' of FIG. 3.

In the example shown in FIG. 9B, the first to fourth insulating films 121, 122, 123, and 124 are formed on the substrate 111 as components under the active layer ACT, and the light blocking metal B is disposed under the active layer ACT. However, the transistor according to the embodiment of the present disclosure is not limited to the example shown, and is applicable to a structure from which at least one of the first to fourth insulating films 121, 122, 123, and 124 and the light blocking metal B are omitted.

Hereinafter, an embodiment of a circuit provided in a subpixel in which transistors T1 and T2 have different intrinsic areas will be described.

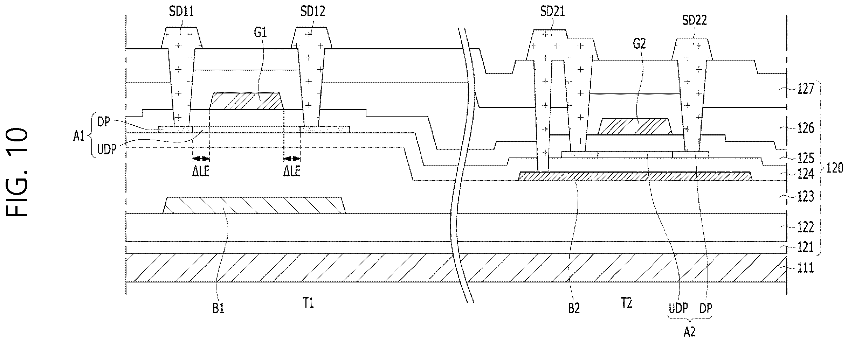

FIG. 10 is a sectional view showing first and second transistors according to an embodiment of the present disclosure.

As shown in FIG. 10, the first transistor T1 according to the embodiment of the present disclosure includes a first light blocking metal B1 on a substrate 111, a first active layer A1 overlapping the first light blocking metal B1, a first gate electrode G1 overlapping a part of an intrinsic area UDP of the first active layer A1, and a first source-drain electrode SD11 and a second source-drain electrode SD12 connected to doped areas DP of the first active layer A1 located on both sides of the first gate electrode G1.

In the first transistor T1, the first gate electrode G1 has an overlap area of length L with the first active layer A1 in the first direction (X-axis or Y-axis) and a width W in the second direction (Y-axis or X-axis) intersecting the first direction, as described with reference to FIGs. 3 to 7. The area of the first active layer A1 overlapping the first gate electrode G1 is an intrinsic area UDP. In addition, the intrinsic area UDP further includes a different extension length ΔLE outward from the first gate electrode G1 in a width direction of the first active layer A1. That is, the first active layer A1 of the first transistor T1 further has a longest intrinsic area UDP outward from the gate electrode G1 at the center of the width W overlapping the first gate electrode G1, a gradually decreasing intrinsic area UDP toward the edge of the width W, and an intrinsic area UDP approximately equal to the edge of the first gate electrode G1 at the edge of the width W. That is, when observing the length of the intrinsic area UDP from the center of the width of the first active layer A1 to the edge, the length of the intrinsic area UDP changes from "L+ΔLE" to "L." That is, the extension length ΔLE of the intrinsic area to the outside of the gate electrode is changed, and "L+ΔLE" may be the length of the channel of the first active layer A1, and the channel length in the first transistor T1 may be "L" or more.

The first light blocking metal B1 may also function as a kind of gate electrode with the function of preventing the first active layer A1 from being affected by light coming from under the substrate 111. In this case, the first light blocking metal B1 is connected to the first gate electrode G1, and a gate voltage signal of the same potential may be applied thereto.

The second transistor T2 includes a second light blocking metal B2 on the substrate 111, a second active layer A2 overlapping the second light blocking metal B2, a second gate electrode G2 overlapping an intrinsic area UDP of the second active layer A2, and a third source-drain electrode SD21 and a fourth source-drain electrode SD22 connected to doped areas DP of the second active layer A2 located on both sides of the second gate electrode G2.

In the example shown, the first and second transistors T1 and T2 have first and second active layers A1 and A2 provided on the same layer.

Of the first and second transistors T1 and T2, the first transistor T1 may have a first active layer A1 formed so as to have a large width for relatively high power output.

When the first active layer A1 has a large width, the diffusion area may have an extension length ΔLE outside the first gate electrode G1 even when conductance diffusion due to diffusion of a dopant occurs during the process or during driving when the first active layer A1 further includes an intrinsic area UDP of a changed extension length ΔLE outside the first gate electrode G1 in the width direction, and therefore the diffusion of the dopant under the first gate electrode G1 may be prevented, thereby preventing defects due to changes in the effective channel length.

In the first and second transistors T1 and T2, the first and second light blocking metals B1 and B2 are located on different layers. The first transistor T1 having the third insulating film 123 further provided between the first active layer A1 and the first light blocking metal B1 may prevent an excessive increase of electrons at the interface of the first active layer A1 and prevent a decrease in the amount of charge in the channel of the first active layer A1 over time. Thus, the first transistor T1 may have a high-speed response, such as a switching transistor, with improved reliability.

The second light blocking metal B2 may be connected to the third source-drain electrode SD21 together with the second active layer A2 and controlled to the same potential.

The first and second transistors T1 and T2 may effectively block light incoming from below, for example, if the first and second active layers A1 and A2 include semiconductors having sensitivity to light, and may prevent an increase in the off-current of the first and second active layers A1 and A2 due to light incidence, thereby improving reliability.

The second transistor T2 may have a shorter channel than the first transistor T1. In this case, the second transistor T2 having a small-width channel may generate little joule heat in the width direction during heat treatment or driving. Therefore, since the second transistor T2 is not particularly sensitive to width, no separate offset mask is provided on the second gate electrode G2, and a phenomenon of diffusion of the dopant overlapping the second gate electrode G2 may not occur when doping is performed using the second gate electrode G2.

Therefore, the first and second transistors T1 and T2 having large and small widths may be formed with differences in whether to include an intrinsic area UDP deviating from the gate electrodes G1 and G2.

The first transistor which has relatively fast response and to which a high-voltage gate voltage is applied may be a transistor having a large width, and may further include an intrinsic area UDP deviating from the gate electrode G1.

The first transistor T1 may be a switching transistor and the second transistor T2 may be a driving transistor. However, the transistors according to the embodiment of the present disclosure are not limited thereto, and each of the first and second transistors T1 and T2 may include an intrinsic area deviating from the gate electrode, or the second transistor T2 may be formed so as to include an intrinsic area deviating from the gate electrode.

When convex intrinsic areas are further provided on both sides of the gate electrode for a transistor having a large width, the intrinsic areas may perform an offset function even if there is a dopant that is diffused during process or driving and may prevent the dopant from permeating the lower side of the gate electrode, whereby it is possible to prevent a change in the channel length of the active layer and to prevent a change in the threshold voltage due to a reduction of the channel area.

When the large-width transistor and the small-width transistor are provided together in a subpixel or a driving unit, a change in the threshold voltage of the large-width transistor may be prevented or reduced to prevent a characteristic difference such as the threshold voltage difference between the large-width transistor and the small-width transistor to maintain the operation stability of the subpixel or the driving unit.

In addition, when a transistor having a convex intrinsic area on both sides of the gate electrode is disposed in the driving unit, it is possible to prevent or reduce a change in the length of the channel by area in response to the joule heating characteristic, thereby minimizing a change in the length of the channel in the entire active layer, and therefore it is possible to design a high-power transistor with a smaller area than a structure formed with a margin of the channel length reduction ΔL, which enables a narrow bezel.

The first to sixth insulating films 121, 122, 123, 124, 126, and 127 and the gate insulating film 125 may have the same or similar disposition and function as the insulating films of the transistor described with reference to FIGs. 5 to 7.

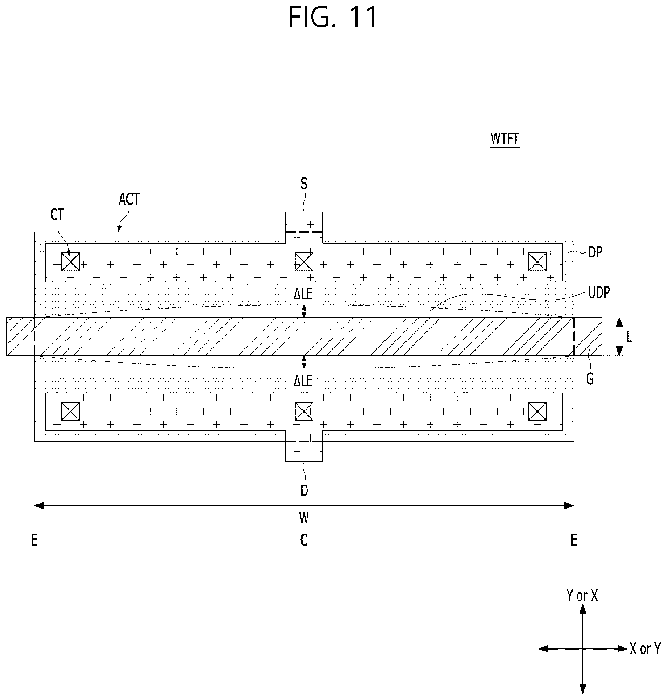

FIG. 11 is a plan view showing a third transistor according to an embodiment of the present disclosure.

As shown in FIG. 11, the third transistor WTFT according to the embodiment of the present disclosure is configured such that an active layer ACT overlaps a gate electrode G by a length L and has a width W greater than the length L.

The overlap area between the active layer ACT and the gate electrode G has a length L in the first direction (Y-axis or X-axis) and a width W in the second direction (X-axis or Y-axis) intersecting the first direction.

As shown in FIG. 11, the third transistor WTFT has an intrinsic area UDP that protrudes farther outward from the center C of the width W of the active layer ACT, an intrinsic area UDP gradually decreasing toward the edge E, and an intrinsic area UDP corresponding to the length L of the gate electrode G at the edge E. The remaining area of the active layer ACT excluding the intrinsic area UDP is a doped area DP, and a source electrode S and a drain electrode D are connected to the doped area DP located on both sides via a contact hole CT while being spaced apart from the gate electrode G.

The sectional shape of the third transistor WTFT may be the same as the sectional structure described with reference to FIGs. 5 to 7.

The third transistor WTFT may be used in a driving unit provided in a non-display area NA of the substrate, such as a buffer transistor of a gate-in-panel (GIP), and has a large channel to facilitate high current generation.

In addition, another intrinsic area is provided from the center to the edge with respect to the large width, whereby, even if the conductorization diffusion distribution by the joule heat generation differs by area, the diffused dopant does not overlap the gate electrode G, thereby preventing or reducing the change of the effective channel length, and therefore it is possible to prevent a change in threshold voltage caused by a change of the channel length and to improve reliability of the device.

Hereinafter, a display device according to an embodiment of the present disclosure will be described.

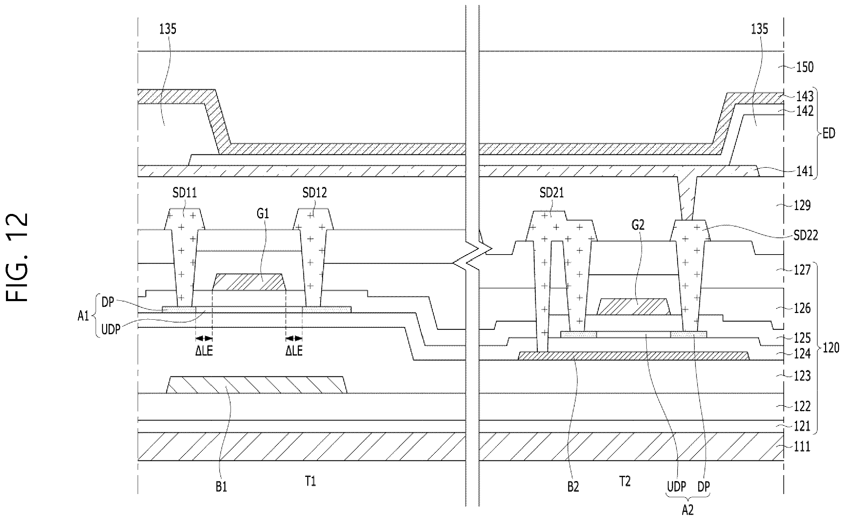

FIG. 12 is a sectional view showing a display device according to an embodiment of the present disclosure.

A substrate 111 may be made of a plastic material so as to be flexible. In one example, the substrate 111 may include first and second organic films overlapping each other with an inorganic interlayer insulating film therebetween. The first and second organic films may include the same organic film or different organic films, such as polyethylene terephthalate (PET) and polyimide. In some case, an adhesive film, such as a pressure sensitive adhesive PSA, may be provided between first and second organic films.

In another example, the substrate 111 may include a flexible, thin glass material.

The substrate 111 serves to support and protect the components of the display device 1000 disposed thereon.

A plurality of stacked insulating films 120 (121 and 122, 123, 124, 125, 126, and 127) is disposed in the display area AA and the non-display area NA (see FIG. 1) of the substrate 111 such that the electrodes B1, G1, SD11/SD12, B2, G2, and SD21/SD22 constituting the first and second transistors T1 and T2 can be insulated from each other. The insulating films 120 may include a first insulating film 121, a second insulating film 122, a third insulating film 123, a fourth insulating film 124, a gate insulating film 125, a fifth insulating film 126, and a sixth insulating film 127.

The first insulating film 121 is disposed in the display area AA and the non-display area NA of the substrate 111. The first insulating film 121 may be referred to as a buffer layer and may perform the same function as a buffer layer known in the art. The first insulating film 121 may be disposed on the substrate 111 to protect structures located on the substrate 111 from moisture permeating through the substrate 111 and to planarize the surface of the substrate 111.

The first insulating film 121 may extend to an edge of the substrate 111 to prevent permeation of moisture from the edge of the substrate 111. The first insulating film 121 may be constituted by a single inorganic film or a plurality of alternately stacked inorganic films.

For example, the first insulating film 121 may include at least one of a silicon oxide film (SiOx), a silicon nitride film (SiNx), and a silicon oxynitride film (SiOxNy), or a multilayer film formed by stacking the inorganic films.

The second insulating film 122 may be disposed on the first insulating film 121. The second insulating film 122 may function, for example, as a second buffer layer. In this case, some of transistors included in a subpixel may include a polysilicon semiconductor layer (not shown), and the second insulating film 122 may be located under the polysilicon semiconductor layer. The second insulating film 122 may include an inorganic film, such as a silicon oxide film (SiOx) or a silicon nitride film (SiNx), or a multilayer film thereof. In some cases, the second insulating film 122 may be used as a gate insulating film of a transistor including a polysilicon semiconductor layer.

A first light blocking metal B1 made of a conductive metal material may be provided on the second insulating film 122. Specifically, the conductive metal material may include at least one of an aluminum-based metal, such as aluminum (Al) or an aluminum alloy, a silver-based metal, such as silver (Ag) or a silver alloy, a copper-based metal, such as copper (Cu) or a copper alloy, a molybdenum-based metal, such as molybdenum (Mo) or a molybdenum alloy, chromium (Cr), tantalum (Ta), neodymium (Nd), and titanium (Ti).

The first light blocking metal B1 may form one electrode of a storage capacitor included in the subpixel.

The third insulating film 123 may be disposed on the second insulating film 122 where the first light blocking metal B1 is disposed. The third insulating film 123 may function as an insulator of a storage capacitor connected to at least one of the first and second transistors T1 and T2. Alternatively, the third insulating film 123 may function as an interlayer insulating film of a transistor including a polysilicon semiconductor layer.

The third insulating film 123 may include an inorganic material. The inorganic material may include, for example, a silicon nitride film (SiNx).

A second light blocking metal B2 made of a conductive metal material is disposed on the third insulating film 123. The conductive metal material may include at least one of an aluminum-based metal, such as aluminum (Al) or an aluminum alloy, a silver-based metal, such as silver (Ag) or a silver alloy, a copper-based metal, such as copper (Cu) or a copper alloy, a molybdenum-based metal, such as molybdenum (Mo) or a molybdenum alloy, chromium (Cr), tantalum (Ta), neodymium (Nd), and titanium (Ti).

The first and second light blocking metals B1 and B2 may be disposed on the same layer as the first and second electrodes of the storage capacitor, respectively. Each of the first and second light blocking metals B1 and B2 may be formed as a single layer, or may have a structure in which a plurality of different metal materials is stacked.

The fourth insulating film 124 may be disposed on the third insulating film 123 where the second light blocking metal B2 is provided. The fourth insulating film 124 may be located under the first and second active layers A1 and A2 and may function as a buffer layer. The fourth insulating film 124 may serve to planarize the surface of the area where the first and second active layers A1 and A2 are formed.

The fourth insulating film 124 may include an inorganic material. The inorganic material may include, for example, a silicon oxide film (SiOx) or a multilayer film formed by stacking inorganic films.

The first and second active layers A1 and A2 are disposed on the fourth insulating film 124. Each of the first and second active layers A1 and A2 includes an oxide semiconductor material. The oxide semiconductor material may include a combination of at least one of zinc (Zn), indium (In), gallium (Ga), tin (Sn), and titanium (Ti) and an oxide. In some cases, a highly conductive metal, such as iron (Fe), may be further included in the oxide semiconductor material to increase mobility.

More specifically, the oxide semiconductor material constituting the first and second active layers A1 and A2 may be, for example, zinc oxide (ZnO), zinc-tin oxide (ZTO), zinc-indium oxide (ZIO), indium oxide (InO), titanium oxide (TiO), indium-gallium-zinc oxide (IGZO), indium-zinc-tin oxide (IZTO), or iron-indium-zinc oxide (FIZO).

The gate insulating film 125 is disposed so as to cover the first active layer A1 and the second active layer A2.

First and second gate electrodes G1 and G2 partially overlapping the first active layer A1 and the second active layer A2 are disposed on the gate insulating film 125. Each of the first and second gate electrodes G1 and G2 may include at least one of an aluminum-based metal, such as aluminum (Al) or an aluminum alloy, a silver-based metal, such as silver (Ag) or a silver alloy, a copper-based metal, such as copper (Cu) or a copper alloy, a molybdenum-based metal, such as molybdenum (Mo) or a molybdenum alloy, chromium (Cr), tantalum (Ta), neodymium (Nd), and titanium (Ti). Each of the first and second gate electrodes G1 and G2 may have a single layer structure or a multilayer structure.

The first gate electrode G1 may be connected to, for example, the gate line G1 described with reference to FIG. 1.

In an embodiment of the present disclosure, the first gate electrode G1 may be connected to the first light blocking metal B1 located thereunder such that a gate voltage signal having the same potential can be applied thereto. In this case, the potential stabilization of the first light blocking metal B1 and the application of the dual gate structure of the first transistor T1 enable high-speed operation with a small size.

After forming the first gate electrode G1, an offset mask OFM (see FIG. 9B) covering the top and the side of the first gate electrode G1 is further formed and a doping process is carried out. Consequently, the intrinsic area UDP of the first active layer A1 may further extend from the edge of the first gate electrode G1 and may be disposed with an extending distance of the extension length ΔLE. The distance of the intrinsic area UDP extending from the edge of the first gate electrode G1 may gradually decrease from the center C to the edge E of the width W of the first active layer A1, as described with reference to FIGS. 3, 4, and 11.

Thus, the first active layer A1 has more of the intrinsic area UDP protruding from the center of the width of the overlap area overlapped with the first gate electrode G1 to the non-overlap area not overlapped with the first gate electrode G1 than the edge of the width of the overlap area overlapped with the first gate electrode G1. Consequently, the first active layer A1 has, an intrinsic area UDP in a convex shape outward from both edges of the first gate electrode G1 and a doped area DP outside the intrinsic area UDP, in addition to the overlap area overlapped with the first gate electrode G1.

The second active layer A2 includes the area overlapping the second gate electrode G2 as an intrinsic area UDP and the area outside the second gate electrode G2 as a doped area DP.

The fifth insulating film 126 and the sixth insulating film 127 are disposed on the gate insulating film 125 where the first and second gate electrodes G1 and G2 are disposed.

Each of the fifth insulating film 126 and the sixth insulating film 127 is made of an inorganic insulating material, and in some cases may have a single layer structure.

Each of the fifth insulating film 126 and the sixth insulating film 127 may include, for example, a silicon oxide film (SiOx) or a silicon nitride film (SiNx), or may include a multilayer film formed by stacking the inorganic films.

The sixth insulating film 127, the fifth insulating film 126, and the gate insulating film 125 are selectively removed to form a contact hole through which the doped areas DP of the first and second active layers A1 and A2 are exposed, and the first active layer A1 is connected to the first source-drain electrode SD11 and the second source-drain electrode SD12, and the second active layer A2 is connected to the third source-drain electrode SD21 and the fourth source-drain electrode SD22, through the contact hole.

Each of the first to fourth source-drain electrodes SD11, SD12, SD21, and SD22 may include at least one of an aluminum-based metal such as aluminum (Al) or an aluminum alloy, a copper-based metal such as copper (Cu) or a copper alloy, a molybdenum-based metal such as molybdenum (Mo) or a molybdenum alloy, chromium (Cr), tantalum (Ta), neodymium (Nd), and titanium (Ti). Each of the first and second gate electrodes G1 and G2 may have a single layer structure or a multilayer structure.

The third source-drain electrode SD21 is connected to the second light blocking metal B2 located under the second active layer A2 further extending from one side of the second active layer A2, and may stabilize the potential of the second light blocking metal B2.

The first transistor T1 includes a first light blocking metal B1 on the substrate 111, a first active layer A1 overlapping the first light blocking metal B1, a first gate electrode G1 overlapping a part of an intrinsic area UDP of the first active layer A1, and a first source-drain electrode SD11 and a second source-drain electrode SD12 connected to doped areas DP of the first active layer A1 located on both sides of the first gate electrode G1.

The second transistor T2 includes a second light blocking metal B2 on the substrate 111, a second active layer A2 overlapping the second light blocking metal B2, a second gate electrode G2 overlapping an intrinsic area UDP of the second active layer A2, and a third source-drain electrode SD21 and a fourth source-drain electrode SD22 connected to doped areas DP of the second active layer A2 located on both sides of the second gate electrode G2.

A planarization film 129 configured to protect the first and second transistors T1 and T2 may be provided on the first to fourth source-drain electrodes SD11, SD12, SD21, and SD22.

The planarization film 129 may include an organic material. The organic material may include at least one of an acrylic resin, a phenolic resin, a polyimide resin, an unsaturated polyester resin, a polyamide resin, benzocyclobutene, a polyphenylene resin, and a polyphenylene sulfide resin.

An anode 141 may be further provided on the planarization film 129 and may be connected to the fourth source-drain electrode SD22 via a contact hole in the planarization film 129.

The anode 141, a cathode 143 opposite the anode, and an intermediate layer 142 between the anode 141 and the cathode 143 constitute a light emitting element ED.

One of the anode 141 and the cathode 143 may include a reflective electrode, and the other may include a transparent electrode or a reflective-transmissive electrode.

When the anode 141 includes a reflective electrode, the anode 141 may function to prevent incidence of light on the transistor TFT thereunder. The anode 141 may include, for example, a structure in which a first transparent electrode, a reflective electrode, and a second transparent electrode are stacked. The second transparent electrode, which is the uppermost electrode of the anode 141, may be a dielectric, which may lower the barrier to hole injection at the interface with the intermediate layer 142. Here, each of the first and second transparent electrodes may be a transparent oxide electrode such as ITO or IZO. The reflective electrode may include silver, a silver alloy such as APC (Ag-Pd-Cu), aluminum, or an aluminum alloy.

For example, the anode 141 may be formed as a multilayer structure, such as a stacked structure of aluminum (Al) and titanium (Ti) (Ti/Al/Ti), a stacked structure of aluminum (Al) and ITO (ITO/Al/ITO), an APC (Ag/Pd/Cu) alloy, and a stacked structure of an APC alloy and ITO (ITO/APC/ITO), or a stacked structure of silver (Ag) and a molybdenum and titanium alloy (Ag/MoTi), or may include a single layer structure having any one material selected from among silver (Ag), aluminum (Al), molybdenum (Mo), gold (Au), magnesium (Mg), calcium (Ca), and barium (Ba), or an alloy of two or more of the materials.

A pixel defining film 135 may be disposed so as to surround an edge of the anode 141, and a light emitting unit may be defined in an open area of the pixel defining film 135.

The pixel defining film 135 may include an inorganic material or an organic material. The pixel defining film 135 may include an opaque material (e.g., black) configured to prevent light interference between neighboring subpixels SP. In this case, the pixel defining film 135 may include a light blocking material including at least one of color pigment, organic black, and carbon.

The intermediate layer 142 may include a hole injection layer, a hole transport layer, a light emitting layer, an electron transport layer, and an electron injection layer. The intermediate layer 142 may be formed in a tandem structure including a plurality of stacks, each including a hole transport layer, a light emitting layer, and an electron transport layer, and a charge generating layer provided between the stacks. The charge generating layer may include, for example, an n-type charge generating layer and a p-type charge generating layer.

The light emitting layer included in the intermediate layer 142 may be configured differently for each subpixel SP. The light emitting layer EL may include a red light emitting layer that emits red light, a green light emitting layer that emits green light, and a blue light emitting layer that emits blue light. The red light emitting layer, the green light emitting layer, and the blue light emitting layer may be disposed on the anode 141 for each subpixel SP.

For example, a red light emitting layer may be patterned and disposed on a red subpixel, a green light emitting layer may be patterned and disposed on a green subpixel, and a blue light emitting layer may be patterned and disposed on a blue subpixel. However, the present disclosure is not necessarily limited thereto, and at least two of the red light emitting layer, the green light emitting layer, and the blue light emitting layer may be stacked and disposed in one subpixel SP.

The light emitting layer EL may be a white light emitting layer that emits white light. In this case, the light emitting layer EL may be in the form of a common layer in which one or more layers are disposed in common on the subpixels SP rather than in a pattern on the subpixels SP.

As described above, the layer 142 may be disposed in a tandem structure of two or more stacks. In this case, each of the light emitting elements ED may include a charge generating layer disposed between the stacks. The charge generating layer may be a common layer disposed on the entirety of the display area AA.

The cathode 143 may be formed by thinning a transmissive electrode, such as ITO or IZO, or a reflective-transmissive electrode, such as silver, a silver alloy, magnesium, a magnesium alloy, ytterbium (Yb), or a ytterbium alloy. In another embodiment, the cathode 143 may be partially removed from the transmission unit or formed with a small thickness in order to increase transmittance in the transmission unit. The cathode 143 may be a common layer commonly disposed in the subpixels SP to apply the same voltage. To this end, the cathode 143 may extend from the display area AA to a part of the non-display area NA.

The cathode 143 may be a light-transmissive electrode. The cathode 143 may include a transparent conductive material (TCO) such as ITO or IZO, or a semi-transmissive conductive material such as magnesium (Mg), silver (Ag), or an alloy of magnesium (Mg) and silver (Ag), which is capable of transmitting light. If the cathode 143 is made of a semi-transmissive conductive material, light emission efficiency may be increased by microcavities.

The front-emitting type light emitting element has been described above as an example of the light emitting element ED. However, the present disclosure is not limited thereto, and the light emitting element ED may be a bottom emitting type light emitting element in which light emitted from the intermediate layer 142 is emitted toward the substrate 111. In this case, the anode 141 may be made of a transparent or translucent electrode material, and the cathode 143 may be made of a reflective electrode material.

An encapsulation layer 150 is disposed on the light emitting element ED. The encapsulation layer 150 may cover the display area AA and the non-display area NA to prevent permeation of oxygen or moisture into the light emitting element ED. Other layers, such as a capping layer, may be interposed between the encapsulation layer 150 and the cathode 143 as needed.

The encapsulation layer 150 may include a plurality of layers. The encapsulation layer 150 may have a structure in which an inorganic film including an inorganic insulating material and an organic film including an organic insulating material are alternately stacked. For example, the inorganic insulating material may include one or more materials such as silicon oxide, silicon nitride, and/or silicon oxynitride.

The organic insulating material may include at least one selected from the group consisting of polyethylene terephthalate, polyethylene naphthalate, polycarbonate, polyimide, polyethylene sulfonate, polyoxymethylene, polyarylate, and hexamethyldisiloxane.

A capping layer (not shown) may be further formed on the cathode 143 to protect the cathode 143 of the light emitting element ED and to increase light emission efficiency in an upward direction.

In the transistor according to at least one embodiment of the present disclosure, an offset area may be provided in the non-overlap area not overlapped with the gate electrode in the channel width direction of the active layer, an intrinsic area may be provided such that the center of the channel width is greater than the edge thereof to prepare for further diffusion of the dopant at the center of the channel width, and the area of the active layer overlapping the gate electrode may be maintained as an intrinsic channel area. Thus, it is possible to provide a transistor capable of preventing the effective channel length formed upon ion doping using the gate electrode as a mask from varying in the width direction.

The transistor according to at least one embodiment of the present disclosure has the advantage of process optimization, since the effective channel length change can be controlled by adjustment of the intrinsic area without adding a separate process. Furthermore, it is possible to reduce the amount of the dopant by increasing the intrinsic area, and therefore it is possible to minimize process impurities and to eliminate hazardous processes.

In the transistor according to at least one embodiment of the present disclosure, it is possible to control a change in the effective channel length of a transistor including an oxide semiconductor, thereby improving reliability of the transistor.

In the transistor according to at least one embodiment of the present disclosure, it is possible to prevent or reduce a change in the effective channel length even if the transistor has a large channel width, thereby preventing threshold voltage variation or reducing threshold voltage variation. Thus, the channel length margin may be minimized when implementing a large-width transistor, enabling lower power operation than a structure having a channel length margin.

The display device according to at least one embodiment of the present disclosure may include a large-width transistor with element stability in a display area or a non-display area.

In the display device according to at least one embodiment of the present disclosure, threshold voltage sensitivity due to channel width variation is reduced, thereby providing high design freedom and realizing a narrow bezel by disposing a high power transistor in the non-display area at a small size.

The display device according to at least one embodiment of the present disclosure has the advantage of controlling the effective channel length variation in a large-width transistor and reducing the threshold voltage sensitivity, thereby enabling the application of a large-width transistor with high power at a small size, thereby reducing the power consumption such that low power is used and providing environmental sustainability and social benefits. Thus, it is possible to achieve ESG (environmental/social/governance) goals.

A transistor according to at least one embodiment of the present disclosure may comprise an active layer, a gate electrode having an overlap area of a first length and a first width overlapped with the active layer and a gate insulating film between the active layer and the gate electrode. The active layer may have an intrinsic area protruding from a center of the first width to a non-overlap area not overlapped with the gate electrode more than an edge of the first width.

In a transistor according to at least one embodiment of the present disclosure, the intrinsic area may gradually decrease from the center of the first width to the edge of the first width.

In a transistor according to at least one embodiment of the present disclosure, the intrinsic area of the active layer having the non-overlap area not overlapped with the gate electrode may be continuous to the intrinsic area of the overlap area, and the active layer may have a doped area in the non-overlap area not overlapped with the gate electrode excluding the intrinsic area.

In a transistor according to at least one embodiment of the present disclosure, the intrinsic area of the active layer protruding to the non-overlap area not overlapped with the gate electrode may comprise at least one of a second intrinsic area and a third intrinsic area that is continuous to a first intrinsic area of the active layer that is located in the overlap area overlapped with the gate electrode, and the active layer may have a doped area in the non-overlap area not overlapped with the gate electrode excluding the at least one of the second intrinsic area and the third intrinsic area.

A transistor according to at least one embodiment of the present disclosure may further comprise a first source-drain electrode and a second source-drain electrode connected respectively to doped areas of the active layer located at both sides of the gate electrode.

In a transistor according to at least one embodiment of the present disclosure, a channel length of the active layer may be largest at the center of the first width and smallest at the edge of the first width.

In a transistor according to at least one embodiment of the present disclosure, the active layer may comprise an oxide semiconductor.

A transistor according to at least one embodiment of the present disclosure may further comprise a light blocking metal disposed under the active layer, the light blocking metal continuously overlapping the gate electrode and the intrinsic area located in the non-overlap area not overlapped with the gate electrode.

In a transistor according to at least one embodiment of the present disclosure, a signal identical to a signal applied to the gate electrode may be applied to the light blocking metal.

In a transistor according to at least one embodiment of the present disclosure, the first width may be greater than or equal to the first length.

A display device according to at least one embodiment of the present disclosure may comprise: a substrate having a display area and a non-display area; a plurality of gate lines and a plurality of data lines intersecting each other in the display area, the plurality of gate lines and the plurality of data lines being configured to define a plurality of subpixels; a first transistor and a second transistor in at least one of the plurality of subpixels; a light emitting element connected to the second transistor; and a third transistor provided in the non-display area, wherein at least one of the first transistor, the second transistor, and the third transistor comprises the transistor according to at least one embodiment of the present disclosure.

In a display device according to at least one embodiment of the present disclosure, a width of the active layer of the third transistor may be greater than a width of the active layer of each of the first and second transistors.

In a display device according to at least one embodiment of the present disclosure, the gate electrode of the at least one of the first transistor, the second transistor, and the third transistor may be connected to one of the gate lines.

In a display device according to at least one embodiment of the present disclosure, the intrinsic area protruding from the center of the first width may comprise a second intrinsic area and a third intrinsic area, the active layer may further include a doped area and a first intrinsic area overlapped with the gate electrode and having an area of a length direction and a width direction, and the second and third intrinsic areas may respectively extend to outside from edges of the first intrinsic area in the length direction.

In a display device according to at least one embodiment of the present disclosure, widths of the second and the third intrinsic areas may gradually decrease from the edges of the first intrinsic area in the length direction.

A display device according to at least one embodiment of the present disclosure may comprise a substrate having a display area and a non-display area, a plurality of gate lines and a plurality of data lines intersecting each other in the display area, the plurality of gate lines and the plurality of data lines being configured to define a plurality of subpixels, a first transistor and a second transistor in at least one of the plurality of subpixels, a light emitting element connected to the second transistor, and a third transistor provided in the non-display area. At least one of the first transistor, the second transistor, and the third transistor may comprise an active layer, a gate electrode having an overlap area overlapped with the active layer, and a gate insulating film between the active layer and the gate electrode, and the active layer may have an intrinsic area protruding from a center of a width of the overlap area to a non-overlap area not overlapped with the gate electrode more than an edge of the width of the overlap area.

In a display device according to at least one embodiment of the present disclosure, a width of the active layer of the third transistor may be greater than a width of the active layer of each of the first and second transistors.

In a display device according to at least one embodiment of the present disclosure, the gate electrode may be connected to the gate line.

In a display device according to at least one embodiment of the present disclosure, the intrinsic area of the active layer having the non-overlap area not overlapped with the gate electrode may be continuous to the intrinsic area of the overlap area, and the active layer may have a doped area in the non-overlap area not overlapped with the gate electrode excluding the intrinsic area.

A display device according to at least one embodiment of the present disclosure may further comprise a first source-drain electrode and a second source-drain electrode connected respectively to doped areas of the active layer located at both sides of the gate electrode.

In a display device according to at least one embodiment of the present disclosure, the active layer may comprise an oxide semiconductor.

A display device according to at least one embodiment of the present disclosure may further comprise a light blocking metal disposed under the active layer, the light blocking metal overlapping the gate electrode and the intrinsic area located in the non-overlap area not overlapped with the gate electrode.

In a display device according to at least one embodiment of the present disclosure, a signal identical to a signal applied to the gate electrode may be applied to the light blocking metal.

A transistor according to at least one embodiment of the present disclosure may comprise: an active layer; a gate electrode; and a gate insulating film between the active layer and the gate electrode, wherein the active layer includes a doped area and an intrinsic area including a first intrinsic area overlapped with the gate electrode and having area of a length direction and a width direction, and second and third intrinsic areas respectively extends to outside from edges of the first intrinsic area in the length direction.

In a transistor according to at least one embodiment of the present disclosure, widths of the second and the third intrinsic areas may gradually decrease from the edges of the first intrinsic area in the length direction.

As is apparent from the above description, a transistor according to at least one embodiment of the present disclosure and a display device including the same have the following effects.

In the transistor according to at least one embodiment of the present disclosure, an offset area may be provided in the non-overlap area not overlapped with the gate electrode in the channel width direction of the active layer, an intrinsic area may be provided such that the center of the channel width is greater than the edge thereof to prepare for further diffusion of the dopant at the center of the channel width, and the area of the active layer overlapping the gate electrode may be maintained as an intrinsic channel area. Thus, it is possible to provide a transistor capable of preventing the effective channel length formed upon ion doping using the gate electrode from varying in the width direction.

The transistor according to at least one embodiment of the present disclosure has the advantage of process optimization, since the effective channel length change can be controlled by adjustment of the intrinsic area without adding a separate process. Furthermore, it is possible to reduce the amount of the dopant by increasing the intrinsic area, and therefore it is possible to minimize process impurities and to eliminate hazardous processes.

In the transistor according to at least one embodiment of the present disclosure, it is possible to control a change in the effective channel length of a transistor including an oxide semiconductor, thereby improving reliability of the transistor.

In the transistor according to at least one embodiment of the present disclosure, it is possible to prevent or reduce a change in the effective channel length even if the transistor has a large channel width, thereby preventing threshold voltage variation or reducing threshold voltage variation. Thus, the channel length margin may be minimized when implementing a large-width transistor, enabling lower power operation than a structure having a channel length margin.

The display device according to at least one embodiment of the present disclosure may include a large-width transistor with element stability in a display area or a non-display area.

In the display device according to at least one embodiment of the present disclosure, threshold voltage sensitivity due to channel width variation is reduced, thereby providing high design freedom and realizing a narrow bezel by disposing a high power transistor in the non-display area at a small size.

The display device according to at least one embodiment of the present disclosure has the advantage of controlling the effective channel length variation in a large-width transistor and reducing the threshold voltage sensitivity, thereby enabling the application of a large-width transistor with high power at a small size, thereby reducing the power consumption such that low power is used and providing environmental sustainability and social benefits. Thus, it is possible to achieve ESG (environmental/social/governance) goals.

## Claims

1. A transistor comprising:
an active layer (ACT);
a gate electrode (G) having an overlap area of a first length (L) and a first width (W) overlapped with the active layer (ACT); and
a gate insulating film (125) between the active layer (ACT) and the gate electrode (G),
wherein the active layer (ACT) has an intrinsic area (UDP2, UDP3) protruding from a center (C) of the first width (W) to a non-overlap area not overlapped with the gate electrode (G) more than an edge (E) of the first width (W).

2. The transistor according to claim 1, wherein the intrinsic area (UDP2, UDP3) gradually decreases from the center (C) of the first width (W) to the edge (E) of the first width (W) .

3. The transistor according to claim 1 or 2, wherein:
the intrinsic area (UDP2, UDP3) of the active layer (ACT) protruding to the non-overlap area not overlapped with the gate electrode (G) comprises at least one of a second intrinsic area (UDP2) and a third intrinsic area (UDP3) that is continuous to a first intrinsic area (UDP1) of the active layer (ACT) that is located in the overlap area overlapped with the gate electrode (G), and
the active layer (ACT) has a doped area (DP) in the non-overlap area not overlapped with the gate electrode (G) excluding the at least of the second intrinsic area (UDP2) and the third intrinsic area (UDP3).

4. The transistor according to any of claims 1 to 3, further comprising a first source-drain electrode (S) and a second source-drain electrode (D) connected respectively to doped areas (DP) of the active layer (ACT) located at both sides of the gate electrode (G).

5. The transistor according to any of claims 1 to 4, wherein a channel length of the active layer (ACT) is largest at the center (C) of the first width (W) and smallest at the edge (E) of the first width (W).

6. The transistor according to any of claims 1 to 5, wherein the active layer (ACT) comprises an oxide semiconductor.

7. The transistor according to any of claims 1 to 6, further comprising a light blocking metal (B) disposed under the active layer (ACT), the light blocking metal (B) continuously overlapping the gate electrode (G) and the intrinsic area (UDP2, UDP3) located in the non-overlap area not overlapped with the gate electrode (G).

8. The transistor according to claim 7, further configured such that a signal identical to a signal applied to the gate electrode (G) is applied to the light blocking metal (B) .

9. The transistor according to any of claims 1 to 8, wherein the first width (W) is greater than or equal to the first length (L).

10. A display device (1000) comprising:
a substrate (111) having a display area (AA) and a non-display area (NA);
a plurality of gate lines (GL) and a plurality of data lines (DL) intersecting each other in the display area (AA), the plurality of gate lines (GL) and the plurality of data lines (DL) being configured to define a plurality of subpixels (SP);
a first transistor (T1) and a second transistor (T2) in at least one of the plurality of subpixels (SP);
a light emitting element (ED) connected to the second transistor (T2); and
a third transistor (WTFT) provided in the non-display area (NA), wherein
at least one of the first transistor (T1), the second transistor (T2), and the third transistor (WTFT) comprises the transistor according to any of claims 1 to 9.

11. The display device (1000) according to claim 10, wherein a width of the active layer (ACT) of the third transistor is greater than a width of the active layer (ACT) of each of the first and second transistors (T1, T2).

12. The display device according to claim 10 or 11, wherein the gate electrode (G) of the at least one of the first transistor (T1), the second transistor (T2), and the third transistor (WTFT) is connected to one of the gate lines (GL).

13. The transistor of claim 1, wherein:
the intrinsic area (UDP2, UDP3) protruding from the center (C) of the first width (W) comprises a second intrinsic area (UDP2) and a third intrinsic area (UDP3),
the active layer (ACT) further includes a doped area (DP) and a first intrinsic area (UDP1) overlapped with the gate electrode (G) and having an area of a length direction and a width direction, and
the second and third intrinsic areas (UDP2, UDP3) respectively extend to outside from edges of the first intrinsic area (UDP1) in the length direction.

14. The transistor according to claim 13, wherein widths of the second and the third intrinsic areas (UDP2, UDP3) gradually decrease from the edges of the first intrinsic area (UDP1) in the length direction.
